# EUROPEAN PATENT SPECIFICATION

(11) **EP 2 484 812 B1**
(45) Date of publication and mention of the grant of the patent: **08.11.2017**
(21) Application number: 10820399.3
(22) Date of filing: 21.09.2010
(51) Int. Cl.: C25D 7/06, B32B 15/08, C25D 3/30, H05K 9/00, C25D 5/02, C25D 3/60, C25D 15/00, B32B 15/09

(54) **SN OR SN ALLOY PLATED FILM AND COMPOSITE MATERIAL HAVING THE SAME**
AUS SN ODER EINER SN-LEGIERUNG PLATTIERTER FILM SOWIE VERBUNDMATERIAL DAMIT
FILM PLAQUÉ EN ÉTAIN OU EN ALLIAGE D'ÉTAIN ET MATÉRIAU COMPOSITE LE COMPRENANT

(30) Priority: 30.09.2009 JP 2009227501
(43) Date of publication of application: 08.08.2012
(73) Proprietor: JX Nippon Mining & Metals Corporation, Tokyo 100-8164 (JP)
(72) Inventor: CHIBA Yoshihiro, Hitachi-shi Ibaraki 317-0056 (JP)
(74) Representative: Prüfer & Partner mbB Patentanwälte · Rechtsanwälte
(86) International application number: PCT/JP2010/066294
(87) International publication number: WO 2011/040280

(56) References cited:
- WO-A1-2005/060326
- WO-A1-2009/144973
- JP-A- 2001 098 396
- JP-A- 2009 173 952
- JP-A- 2009 287 095
- JP-A- 2010 236 041
- US-A- 5 871 631
- US-A1- 2006 216 475
- US-B1- 6 395 583
- PARK ET AL: "Effect of temperature on the fretting corrosion of tin plated copper alloy contacts", WEAR, ELSEVIER SEQUOIA, LAUSANNE, CH, vol. 262, no. 3-4, 12 January 2007 (2007-01-12), pages 320-330, XP005827737, ISSN: 0043-1648

## Description

### Field of the Invention

The present invention relates to an Sn or Sn alloy plated film formed on other surface of a copper foil or a copper alloy foil having resin and the like laminated on one side surface thereof, and a composite material comprising the same for use in an electromagnetic shielding material and the like.

### Description of the Related Art

A Sn plated film has characteristics of excellent corrosion resistance, good solderability, and low contact resistance. Accordingly, the Sn plated film is used as a composite material for an electromagnetic shield material of a vehicle by plating Sn on a metal, e.g., copper, foil.

The above composite material has a structure of a copper foil or a copper alloy foil, a resin layer or film laminated on one side surface thereof, and a Sn plated film formed on other surface of the copper foil or the copper alloy foil.

A Sn plating on the copper foil or the copper alloy foil is generally using a wet process. Since the plated film is required to have evenness and be good in appearance, i.e., have a uniform color tone, no color spots and no patterns, additives are often added to a plating solution to provide a bright Sn plating. As a result, the Sn plated film has decreased surface roughness.

As an example, Patent Literature 1 discloses an electromagnetic shielding material obtained by using a copper foil having a reflectance of 1% to 15% manufactured by plating an alloy comprising tin, nickel and molybdenum thereon. In the art, the copper foil has center line average surface roughness of 0.1 to 0.5 µm (1.0 x 10² to 5.0 x 10² nm) before the alloy plating.

On the other hand, whiskers are generated on the Sn plated film because of the inner or outer stress. In order to avoid them, Patent Literatures 2 and 3 disclose that a (202) plane and a (321) plane of the Sn plated film are oriented in a specific percentage.

Non-Patent Literature 1 deals with the fretting corrosion of tin plated copper alloy contacts and the effect of temperature thereon.

[Patent Literature 1] Japanese Unexamined Patent Publication (Kokai) 2003-201597
[Patent Literature 2] Japanese Unexamined Patent Publication (Kokai) 2006-249460
[Patent Literature 3] Japanese Unexamined Patent Publication (Kokai) 2009-24194
[Non-Patent Literature 1] Park et. al, Effect of temperature in the fretting corrosion of tin plated copper alloy contacts, Wear 262 (2007), p. 320-330

### Summary of the Invention

### Problems to be solved by the Invention

The conventional bright Sn plated film has decreased surface roughness Ra. Therefore, when the copper foil strip is plated continuously, friction against a roll at an exit side of a plating bath becomes low, there are problems that the roll is slipped and the Sn plated surface is worn, transferred and adhered to the roll.

For example, the electromagnetic shield material of the vehicle is made by using a composite material comprising the copper foil or the copper alloy foil as the base. In the process of applying a thermoplastic adhesive in continuous lines to manufacture the electromagnetic shield material noted above, the same problems arise. In this process, the speed of the foil passing through the roll is as fast as 40 m to 100 m/min. So, it is obviously observed that Sn is adhered to the roll to be contacted with the plated surface.

In either case, due to the Sn adherence to the roll, maintenance takes a much time and the productivity is therefore decreased. In addition, when the maintenance is not conducted, surface flaws may be caused by the Sn adherence to the roll, resulting in low quality. Furthermore, the Sn adherence to the roll may reduce the thickness of the Sn plated film, which may cause poor corrosion resistance.

On the other hand, the copper foil is thin and has therefore low strength. So, when the copper foil is used as the shielding material, a resin layer or film is generally laminated on the copper foil. However, even if the resin layer or film is laminated on the copper foil, once a high tension is applied to the copper foil strip during continuous plating, breaks and wrinkles are generated. In order to avoid the breaks and wrinkles, the foil should be passed through the roll at low tension. In addition, in the steps of plating and applying the thermoplastic adhesive, the roll having decreased roughness is used in order to avoid the surface flaws. So, resistance between the roll and the Sn plated film is small, and the roll and the plated film are easily slipped. When the plated film has the decreased surface roughness, the slippage is increasingly facilitated.

It is also considered that when the Sn plated film has the decreased surface roughness, organic compounds contained in a gloss agent are co-deposited on the Sn film such that the plated film may be brittle and be dropped off.

When the composite material obtained by Sn plating on the copper foil is used as the electromagnetic shielding material such as the cable, the composite material is wound around the circumference of the cable and the resin is further coated therearound. In this coating step, when the composite material is passed through a die (mold), the Sn plated film may be dropped off and adhere to the die as Sn residues. In order to remove such residues, maintenance may take a much time, resulting in the decreased productivity.

Specifically, the present invention is made to solve the above-mentioned problems. An object of the present invention is to provide a Sn or Sn alloy plated film and a composite material comprising the same having excellent maintenance properties of a roll and improved productivity by preventing the Sn or Sn alloy plated film from wearing or dropout during plating or in use;.

### Means for Solving the Problems

Through diligent studies, the present inventors found that when crystal orientation of the Sn plated film is controlled, the surface roughness can be increased to decrease the Sn plated film from wearing or dropout.

To achieve the above object, the present invention provides a Sn or Sn alloy plated film formed on other surface of a copper foil or a copper alloy foil having a resin layer or film laminated on one side surface thereof, wherein the Sn or Sn alloy plated film has a percentage of (200) plane orientation of 20 to 40%.

The Sn or Sn alloy plated film has a total percentage of (200) and (211) planes orientation of 50 to 65%.

Preferably, the copper foil or the copper alloy foil has a percentage of (111) plane orientation of 20 to 40%.

Preferably, the Sn or Sn alloy plated film has an average thickness of 0.5 to 2 µm.

Preferably, the Sn or Sn alloy plated film is formed by continuous plating.

The present invention provides a composite material comprising a copper foil or a copper alloy foil, a resin layer or film laminated on one side surface of the copper foil or the copper alloy foil, and the Sn or Sn alloy plated film formed on other surface of the copper foil or the copper alloy foil.

Preferably, the composite material has a thickness of 0.1 mm or less, and preferably, the composite material is used in an electromagnetic shield.

In the present invention, crystal orientations of the Sn or Sn alloy plated film and the copper foil or the copper alloy foil can be determined by thin film X-ray diffraction of their surfaces.

The thickness of the Sn or Sn alloy plated film is a macroscopic average thickness of the Sn or Sn alloy plated film and can be determined based on the quantity of electricity, when the plated film is electrolyzed and is fully dissolved.

### Effect of the Invention

According to the present invention, there is provided an Sn or Sn alloy plated film and a composite material comprising the same having excellent maintenance properties of a roll and improved productivity by preventing the Sn or Sn alloy plated film from wearing or dropout.

### Description of the Preferred Embodiments

Embodiments of the present invention will be described below. The symbol "%" herein refers to % by mass, unless otherwise specified.

The composite material according to the embodiment of the present invention comprises a copper foil (or a copper alloy foil) 1, a resin layer (or film) 4 laminated on one surface of the copper foil (or the copper alloy foil) 1, and a Sn or Sn alloy plated film 2 formed on the other surface of the copper foil (or the copper alloy foil) 1.

From a standpoint of obtaining the lighter and thinner material, the composite material has preferably a thickness of 0.1 mm or less.

The copper foil includes tough pitch copper or oxygen-free copper having a purity of 99.9% or more. The copper alloy foil includes known copper alloys depending on the strength or the conductivity as desired. Examples of the known copper alloys include a copper alloy containing 0.01 to 0.3% of tin and a copper alloy containing 0.01 to 0.05% of silver. Among them, Cu-0.12%Sn and Cu-0.02%Ag are often used, since they have excellent conductivity.

The thickness of the copper foil (or the copper alloy foil) is not especially limited. For example, the copper foil (or the copper alloy foil) having a thickness of 5 to 50 µm is preferably used.

The copper foil (or the copper alloy foil) is preferably a rolled copper foil with high strength rather than an electro-deposited copper foil.

The copper foil (or the copper alloy foil) has center line average surface roughness of 0.3 µm or less, preferably 0.2 µm or less so that the surface roughness of the Sn or Sn alloy plated film is not affected

Preferably, the surface of the copper foil (or the copper alloy foil) has a percentage of (111) plane orientation of 20 to 40%. Thus, the flexibility of the copper foil (or the copper alloy foil) is improved. The percentage of the (111) plane orientation of the copper foil (or the copper alloy foil) is controlled to 20 to 40%, for example, by adjusting the reduction ratio in the cold rolling and the heat treatment, and annealing at a temperature of 150°C or more after the cold rolling. If the copper foil (or the copper alloy foil) is annealed at a temperature of less than 150°C after the cold rolling, the percentage of the (111) plane orientation is decreased.

If the percentage of the (111) plane orientation of the copper foil (or the copper alloy foil) is less than 20%, the flexibility may be insufficiently improved. If the percentage of the (111) plane orientation of the copper foil (or the copper alloy foil) exceeds 40%, the strength of the copper foil may be decreased, breaks and wrinkles may be easily generated when the foil is passed through the roll, and the workability may be decreased. The orientation of the copper foil may be measured at the resin layer side or at the Sn plated side, since almost the same orientation strength can be provided. When the orientation of the copper foil on the composite material is measured, the resin layer may be removed by using a solvent or the like and the orientation of the surface of the copper foil may be measured at the resin film side.

It is also confirmed that the orientation strength of the (111) plane is high even in a process annealing in the course of the cold rolling, when the percentage of the (111) plane orientation of the surface of the copper foil (or the copper alloy foil) is 20 to 40%.

The resin layer includes a resin such as polyimide. The film includes polyethylene terephthalate (PET), polyethylene naphtalate (PEN) or the like. The resin layer or the film may be adhered to the copper foil (or the copper alloy foil) with the adhesive. Alternatively, a fused resin may be casted on the copper foil (the copper alloy foil), or the film may be thermally compressed to the copper foil (the copper alloy foil), without using the adhesive.

The thickness of the resin layer or film is not especially limited, but preferably can be 5 to 50 µm. When the adhesive is used, the thickness of the adhesive layer can be, for example, 10 µm or less.

As the Sn alloy plated film, for example, Sn-Cu, Sn-Ag, Sn-Pb and the like can be used.

The Sn or Sn alloy plated film has a percentage of (200) plane orientation of 20 to 40%. Thus, the Sn or Sn alloy plated film may have increased roughness, and friction at contacted portions will be increased. Then, the slippage between the roll and the plated film can be decreased when the plating is performed continuously. In addition, when the resultant composite material is worked into an electromagnetic shield material such as a cable, the Sn or Sn alloy plated film and the roll are less slipped, and the Sn or Sn alloy plated film is less dropped off. Thus, Sn adherence to the roll can be prevented and the workability can be enhanced. Further, when the resultant composite material is worked, no powder may be dropped from the Sn or Sn alloy plated film and fixing strength will not be low.

If the Sn or Sn alloy plated film has the percentage of the (200) plane orientation of less than 20%, the roughness of the plated film cannot be increased, and the friction at the contacted portions cannot be increased. As a result, the slippage between the plated film and the roll is difficult to be decreased.

On the other hand, if the Sn or Sn alloy plated film has the percentage of the (200) plane orientation of exceeding 40%, the roughness of the plated film can be increased, and the friction at the contacted portions can be increased. However, in order to provide the plated film having such properties, the efficiency of the plating may be decreased, uneven appearance (coarse deposition) may be produced to decrease corrosion resistance.

The percentage of the (200) plane orientation of the Sn or Sn alloy plated film can be controlled to 20% or more by adding no gloss agent (for example, commercially available chemicals including formalin, aldehydes, imidazoles and benzal acetone) to the Sn or Sn alloy plating bath. When the gloss agent is not added to the plating bath, it is considered that electrodeposited particles are enlarged to grow the orientation of the (200) plane.

However, a naphthol-based surfactant such as ethoxylated naphthol (EN) may be added to the Sn or Sn alloy plating bath. Also, a nonionic surfactant such as ethoxylated naphthol sulfonic acid (ENSA), polyethylene glycol and polyethylene glycol nonyl phenol ether may be added to the Sn or Sn alloy plating bath. Furthermore, an organic compound such as naphthol having a low gloss effect may be added in addition to the surfactant.

The present inventors have conducted experiments by changing the Sn plating conditions variously. As a result, the percentage of the (200) plane orientation did not never exceed 40%. It is therefore considered that no special control is required so that the percentage of the (200) plane orientation does not exceed 40%.

A more specific method will be described below.

A base of the Sn or Sn alloy plating bath includes phenol sulfonic acid, sulfuric acid and methane sulfonic acid.

The size of the electrodeposited particles can be controlled by decreasing current density, increasing the Sn concentration in the bath, and increasing the bath temperature as the plating conditions. For example, at the current density of 8 to 12 A/dm², the Sn concentration of 30 to 60 g/L, and the bath temperature of 30 to 60°C, the granular electrodeposited Sn (or Sn alloy) can be uniformly electroplated on the surface of the copper foil, and the percentage of the (200) plane orientation can be 20% or more, but is not especially limited thereto, since it depends on the device used.

The Sn or Sn alloy plated film has a total percentage of (200) and (211) planes orientation of 50 to 65%.

When the Sn or Sn alloy plated film has the percentage of the (200) plane orientation of 20 to 40% and also when the Sn or Sn alloy plated film has the total percentage of the (200) and (211) planes orientation of 50 to 65%, the flexibility of the composite material coated with the Sn or Sn alloy plated film tends to be improved. When Sn or Sn alloy is plated on the copper foil (or the copper alloy foil) having the percentage of the (111) plane orientation of 20 to 40%, it has been found that the total percentage of the (200) and (211) planes orientation is 50 to 65%. As described above, when the copper foil (or the copper alloy foil) has the percentage of the (111) plane orientation of 20 to 40%, the flexibility of the copper foil (or the copper alloy foil) is improved. It is therefore considered that the flexibility of the composite material, which comprises the Sn or Sn alloy plated film having the total percentage of the (200) and (211) planes orientation of 50 to 65%, is improved as well.

As described above, when the Sn or Sn alloy plated film has the percentage of the (200) plane orientation of 20 to 40%, the Sn or Sn alloy plated film has surface roughness Ra of 0.7 x 10² nm or more. Ra is herein obtained in accordance with JIS B0601 except that JIS B0601 is applied by extending it three-dimensionally. The JIS standard has no indicator showing average roughness of the surface. The Ra outputted from a surface roughness meter is employed as a three-dimensional value.

When the Sn or Sn alloy plated film has Ra of 0.7 x 10² nm, the Sn or Sn alloy plated film may have increased roughness and friction at contacted portions will be increased. Accordingly, the slippage between the roll and the plated film can be decreased when the plating is performed continuously. In addition, when the resultant composite material is worked into an electromagnetic shield material such as a cable, the Sn or Sn alloy plated film and the roll are less slipped, and the Sn or Sn alloy plated film is less dropped off. Thus, Sn adherence to the roll can be prevented and the workability can be enhanced. Further, when the resultant composite material is worked, no powder may be dropped from the Sn or Sn alloy plated film and fixing strength will not be low.

The upper limit of the surface roughness Ra of the Sn or Sn alloy plated film is not especially limited, since it may change depending on the manufacturing conditions of the Sn or Sn alloy plating and the like. When the Ra exceeds 2.0 x 10² nm, the efficiency of the plating may be decreased, uneven appearance (coarse deposition) may be produced, and the corrosion resistance may be decreased.

In the present invention, a non-contact type surface roughness tester is preferably used to measure the surface roughness Ra of the Sn or Sn alloy plated film. This is because the Sn or Sn alloy plated film is soft. If a contact-type surface roughness tester is used, the Ra cannot be measured accurately. As a result, the measured surface roughness shows greater value regardless of the actual surface roughness. Thus, if the contact type surface roughness tester is used for the measurement, the threshold of the Ra for decreasing the slippage of the roll during continuous plating is unclear.

Accordingly, the non-contact type surface roughness tester is used to measure the surface roughness Ra. Examples of the non-contact type surface roughness tester include a microprobe microscope such as an atomic force microscope and a confocal microscope. An example of the atomic force microscope includes model SPI-4000 (E-Sweep) manufactured by Seiko Instruments Inc.

In order to decrease any measurement errors, the Ra is preferably measured at plural points within a field of view of about 100 x 100 µm, and the measured values are averaged.

Preferably, the Sn or Sn alloy plated film has a thickness of 0.5 to 2.0 µm. If the thickness is less than 0.5 µm, the corrosion resistance and solderability may be decreased. On the other hand, if the Sn or Sn alloy plating is thicker than 2 µm, the corrosion resistance and the solderability are not further improved. Rather, the costs are increased and the productivity is undesirably decreased.

### [Example]

Then, the present invention will be further described in detail by illustrating the following examples, but is not limited thereto.

Tough pitch copper containing 99.9% or more of copper was cold-rolled at reduction ratio of 85 to 95%, and then annealed under the condition shown in Table 1 to provide a copper foil (having a thickness of 7.3 µm). A PET film having a thickness of 12.5 µm was adhered to one side of the copper foil using a thermoplastic adhesive to provide a strip. The strip was faced to a tin anode, and electroplated in a plating cell for continuously plating. A plating bath contained phenolsulfonic acid, 10 g/L of a surfactant (EN) and tin oxide such that the Sn concentration was 25 to 37 g/L. Plating was performed at a bath temperature of 35 to 55°C and a current density shown in Table 1, until a plated thickness also shown in Table 1 was attained. The procedure was repeated five times to provide the samples in Examples 1 to 5.

Orientations of (200) and (211) planes of the resultant Sn plated film were measured by thin film X-ray diffraction. A flat plate monochromator was used as an X-ray optical system. Plane orientations were determined by measuring each peak intensity at an angle of 2θ = 3 to 5 degree. The percentage of each plane orientation was determined as follows. 100 is considered as the plane orientation having the highest detected (peak) intensity. Then, the peak intensity of each plane orientation was represented as a percentage of the peak intensity of (100) plane orientation so that the total percentage in all orientations was 100%.

Similarly, the orientation of the (111) plane on the surface of the copper foil before Sn plating was measured by thin film X-ray diffraction. The percentage of the (111) plane orientation was determined as follows. (100) is considered as the plane orientation having the highest detected (peak) intensity. Then, the peak intensity of (111) plane orientation was represented as a percentage of the peak intensity of (100) plane orientation so that the total percentage in all orientations was 100%.

The surface roughness Ra of the Sn plated film was measured by the atomic force microscope (model SPI-4000 (E-Sweep) manufactured by Seiko Instruments Inc.). The measurement range of the Ra was within 100 x 100 µm, and the measurement mode was DFM.

While the plating was performed continuously, the roll at an exit side of a plating bath was observed. After the foil was passed through the length of 4700 m, when Sn was not observed to be adhered to the roll, it was determined that no Sn adherence. When Sn was not adhered to the roll, it was also determined that no powder was dropped.

For the bending evaluation, a 180 degree bending test was conducted on the resultant composite material to visually inspect the bended part. When the bended part was cracked, it was evaluated as not good. When the bended part was not cracked, it was evaluated as good. In the 180 degree bending test, a test piece (10 mm x 50 mm) was double folded by hand in a direction perpendicular to a longitudinal direction, the folded part was further hand pressed to be contacted intimately, and the test piece was then opened to visually inspect the bended part. The copper foil before plating was also evaluated for the bending evaluation. When the bended part was cracked, "cracked" is denoted in column "bending crack" in Table 1.

In Comparative Example 1, the continuous plating was performed just as in Example 1 except that the current density was 7 A/dm² when Sn was plated.

In Comparative Example 2, the continuous plating was performed just as in Example 1 except that the copper foil was not annealed after the cold-rolling.

In Comparative Example 3, the continuous plating was performed just as in Example 1 except that the current density was 13 A/dm² when Sn was plated.

In Comparative Example 4, the continuous plating was performed just as in Example 1 except that the copper foil was annealed at a temperature of as low as 130°C after the cold-rolling.

The results are shown in Table 1.

| | Copper foil | | | | Sn plating conditions | | Sn plated film | | | | Evaluation | | |
|---|---|---|---|---|---|---|---|---|---|---|---|---|---|
| | Annealing conditions | Percentage of (111) orientation | Elongation (%) | Bending crack | Current density (A/d m2) | Gloss agent | Percentage of (200) orientation | Percentage of (200) and (211) orientations | Surface roughness Ra(nm) | Plated thickness (*µ*m) | Sn adherence to roll | bending evaluation | Powder drop |
| Example 1 | 170°CX1.5hr | 39% | 4,6 | Not cracked | 9 | Not added | 22% | 60% | 1.01x10² | 1,0 | Not adhered | Good | Good |
| Example 2 | 150°CX1hr | 24% | 3,5 | Not cracked | 9 | Not added | 28% | 58% | 1.15x10² | 1,3 | Not adhered | Good | Good |
| Example 3 | 150°CX0.5hr | 21% | 3,2 | Not cracked | 9 | Not added | 39% | 63% | 0.98x10² | 1,1 | Not adhered | Good | Good |
| Example 4 | 150°CX1.5hr | 28% | 3,7 | Not cracked | 9 | Not added | 35% | 53% | 0.84x10² | 0,9 | Not adhered | Good | Good |
| Example 5 | 170°CX1hr | 35% | 4,4 | Not cracked | 9 | Not added | 33% | 51% | 0.76x10² | 0,8 | Not adhered | Good | Good |
| Comparative Example 1 | 150°CXlhr | 23% | 3,4 | Not cracked | 7 | Not added | 15% | 52% | 0.48x10² | 1,0 | Adhered | Good | Not good |
| Comparative Example 2 | - | 8% | 1,5 | Cracked | 9 | Not added | 26% | 43% | 1.95x10² | 1,7 | Not adhered | Not good | Good |
| Comparative Example 3 | 170°CX1hr | 32% | 3,9 | Not cracked | 13 | Added | 18% | 45% | 0.67x10² | 1,1 | Adhered | Good | Not good |
| Comparative Example 4 | 130°CX0.5hr | 15% | 2,0 | Cracked | 9 | Not added | 32% | 69% | 0.88x10² | 0,9 | Not adhered | Not good | Good |

As shown in Table 1, in Examples 1 to 5 where the Sn plated film had the percentage of the (200) plane orientation of 20 to 40%, Sn was not adhered to the roll, and no powder was dropped. Also, since the samples in Examples 1 to 5 used the copper foil having the percentage of the (111) plane orientation of 20 to 40%, the bending evaluation of the copper foil and the composite material were also excellent.

On the other hand, in Comparative Example 1 where the current density was 7 A/dm² when Sn was plated, the Sn plated film had the percentage of the (200) plane orientation of less than 20%, Sn was adhered to the roll, and powder was dropped. It is conceivable that the surface roughness of the Sn plated film of the sample in Comparative Example 1 was smaller than those of the samples in Examples 1 to 5.

In Comparative Example 2 where the copper foil was not annealed after the cold-rolling, the percentage of the (111) plane orientation of the copper foil was less than 20%, and the bending evaluation of the copper foil and the composite material were poor.

In Comparative Example 3 where the current density was 13 A/dm² when Sn was plated and the gloss agent (formalin 10 mL/L, amine aldehyde 0.5 mL/L) was added to the Sn plating bath, the Sn plated film had the percentage of the (200) plane orientation of less than 20%, Sn was adhered to the roll, and powder was dropped. It is conceivable that the surface roughness of the Sn plated film of the sample in Comparative Example 3 was smaller than those of the samples in Examples 1 to 5.

In Comparative Example 4 where the copper foil was annealed at a temperature of as low as 130°C after the cold-rolling, the percentage of the (111) plane orientation of the copper foil was less than 20%, and the bending evaluation of the copper foil and the composite material were poor.

### Brief Description of the Drawing

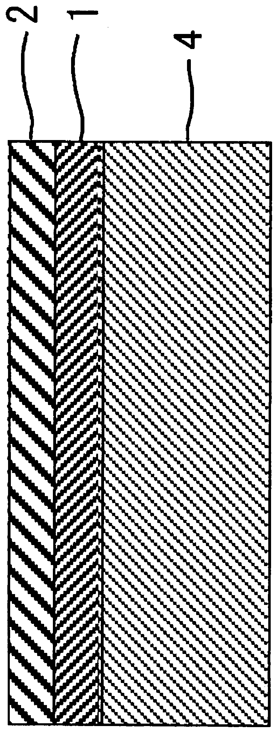

Fig. 1 shows an example of the composite material according to the present invention.

### Description of Reference Numerals

1 Copper foil (or copper alloy foil)
2 Sn or Sn alloy plated film
3 Resin layer (or film)

## Claims

1. A composite material for an electromagnetic shield comprising a copper foil or a copper alloy foil, a resin layer or film laminated on one side surface of the copper foil or the copper alloy foil, and a Sn or Sn alloy plated film formed on the other surface of the copper foil or the copper alloy foil, wherein the Sn or Sn alloy plated film has a percentage of (200) plane orientation of 20 to 40%,
said plane orientation being measured by thin film X-ray diffraction, the percentage of each plane orientation being determined by representing the peak intensity of each plane orientation as a percentage so that the total percentage in all orientations is 100%,
wherein the Sn or Sn alloy plated film has a total percentage of (200) and (211) planes orientation of 50 to 65%.

2. The composite material according to Claim 1, wherein the copper foil or the copper alloy foil has a percentage of (111) plane orientation of 20 to 40%.

3. The composite material according to any one of Claims 1 or 2, wherein the Sn or Sn alloy plated film has an average thickness of 0.5 to 2 µm.

4. The composite material according to any one of Claims 1 to 3, wherein the Sn or Sn alloy plated film is formed by continuous plating.

5. The composite material according to Claim 1, wherein the composite material has a thickness of 0.1 mm or less.

## Patentansprüche

1. Verbundmaterial für eine elektromagnetisches Abschirmung, umfassend eine Kupferfolie oder eine Folie aus Kupferlegierung, eine Schicht oder einen Film aus Harz, welche(r) auf einer Oberflächenseite der Kupferfolie oder der Folie aus Kupferlegierung laminiert ist, und einen plattierten Film aus Sn oder Sn-Legierung, welcher auf der anderen Oberfläche der Kupferfolie oder der Folie aus Kupferlegierung ausgebildet ist, wobei der plattierte Film aus Sn oder Sn-Legierung einen Prozentsatz einer Ausrichtung der (200)-Ebene von 20 bis 40% aufweist, wobei die Ebenenausrichtung durch Dünnfilm-Röntgendiffraktometrie gemessen ist, wobei der Prozentsatz jeder Ebenenausrichtung durch Darstellen der Peak-Intensität jeder Ebenenausrichtung als ein Prozentsatz bestimmt ist, so dass der Gesamt-Prozentsatz in allen Ausrichtungen 100% beträgt,
wobei der plattierte Film aus Sn oder Sn-Legierung einen Gesamt-Prozentsatz von Ausrichtungen der (200)- und (211)-Ebenen von 50 bis 65% aufweist.

2. Verbundmaterial gemäß Anspruch 1, wobei die Kupferfolie oder die Folie aus Kupferlegierung einen Prozentsatz der Ausrichtung der (111)-Ebene von 20 bis 40% aufweist.

3. Verbundmaterial gemäß einem der Ansprüche 1 oder 2, wobei der plattierte Film aus Sn oder Sn-Legierung eine durchschnittliche Dicke von 0,5 bis 2 µm aufweist.

4. Verbundmaterial gemäß einem der Ansprüche 1 bis 3, wobei der plattierte Film aus Sn oder Sn-Legierung durch kontinuierliches Plattieren ausgebildet ist.

5. Verbundmaterial gemäß Anspruch 1, wobei das Verbundmaterial eine Dicke von 0,1 mm oder weniger aufweist.

## Revendications

1. Matériau composite pour un écran électromagnétique comprenant une feuille en cuivre ou une feuille en alliage de cuivre, une couche ou un film de résine stratifié(e) sur une surface latérale de la feuille en cuivre ou de la feuille en alliage de cuivre, et un film de revêtement en Sn ou en alliage de Sn formé sur l'autre surface de la feuille en cuivre ou de la feuille en alliage de cuivre, dans lequel le film de revêtement en Sn ou en alliage de Sn présente un pourcentage d'orientation selon le plan (200) de 20 à 40 %, ladite orientation selon un plan étant mesurée par diffraction de rayons X sur film mince, le pourcentage de chaque orientation selon un plan étant déterminé par la représentation de l'intensité pic de chaque orientation selon un plan en tant que pourcentage, de sorte que le pourcentage total dans toutes les orientations soit de 100 %,
dans lequel le film de revêtement en Sn ou en alliage de Sn présente un pourcentage total d'orientation selon les plans (200) et (211) de 50 à 65 %.

2. Matériau composite selon la revendication 1, dans lequel la feuille en cuivre ou la feuille en alliage de cuivre présente un pourcentage d'orientation selon le plan (111) de 20 à 40 %.

3. Matériau composite selon l'une quelconque des revendications 1 ou 2, dans lequel le film de revêtement en Sn ou en alliage de Sn présente une épaisseur moyenne de 0,5 à 2 µm.

4. Matériau composite selon l'une quelconque des revendications 1 à 3, dans lequel le film de revêtement en Sn ou en alliage de Sn est formé par revêtement continu.

5. Matériau composite selon la revendication 1, dans lequel le matériau composite présente une épaisseur de 0,1 mm ou inférieure.
